# EUROPÄISCHE PATENTANMELDUNG

(11) **EP 4 462 613 A1**
(43) Veröffentlichungstag der Anmeldung: **13.11.2024**
(21) Anmeldenummer: 24167619.6
(22) Anmeldetag: 28.03.2024
(51) Int. Cl.: H01R 13/6474, H01R 13/66, H05K 1/02, H01R 24/64

(54) **ELEKTRISCHER VERBINDER FÜR EIN DATEN- ODER KOMMUNIKATIONSKABEL**

(30) Priorität: 11.05.2023 DE 102023112513
(71) Anmelder: METZ CONNECT TECH GmbH, 78176 Blumberg (DE)
(72) Erfinder: Merk, Benjamin, 78176 Blumberg (DE)
(74) Vertreter: Westphal, Mussgnug & Partner Patentanwälte mbB

(57) **Zusammenfassung**

Elektrischer Verbinder (1) für ein Daten- oder Kommunikationskabel mit folgenden Merkmalen:
- ein Gehäuse (10),
- eine im Gehäuse (10) mindestens teilweise angeordnete Platine (20),
- erste Kontaktelemente (21) und zweite Kontaktelemente (22), welche an der Platine (20) angeordnet sind, wobei
- jedes der ersten Kontaktelemente (21) mittels einer Leiterbahn (60) mit einem zweiten Kontaktelement (22) elektrisch verbunden ist,
- mindestens einer Leiterbahn (60), welche vom ersten Kontaktelement (21) zum zweiten Kontaktelement (22) mindestens drei unterschiedliche Leiterbahnbreiten (B1-B3) aufweist,
gekennzeichnet durch die weiteren Merkmale:
- die Leiterbahnbreite (B1-B3) ausgehend vom zweiten Kontaktelement (22) zum ersten Kontaktelement (21) bei mindestens drei aufeinanderfolgenden Leiterbahnbreiten (B1-B3) stetig oder stufenweise abnehmend ist,
- der Abstand (63) der beiden Leiterbahnen (60) einer differentiellen Leitung (62) über jeden der mindestens drei aufeinanderfolgenden Leiterbahnbreiten (B1-B3) zumindest teilweise gleichbleibend ausgebildet ist.

## Beschreibung

Die Erfindung betrifft einen elektrischen Verbinder für ein Daten- oder Kommunikationskabel gemäß den Merkmalen des Oberbegriffs des Anspruchs 1.

In dem Artikel "Steckverbinder-Basics: Optimierung von Highspeed-Steckverbinder" von Jan Lehmann aus dem Fachjournal von Elektronik Praxis vom 30. Oktober 2020 wird ein Steckverbinder beschrieben, welcher eine Optimierung eines Steckverbinders mittels einer Impedanzanpassung beschreibt. Es wird darauf hingewiesen, dass sich die Impedanz entlang des Signalpfades, abhängig von Geometrie- und Querschnittsänderung des Signalpfades, ändert. Zusätzlich wird auf die Abhängigkeit der Impedanz bezüglich der Anordnung und Geometrie der Signal-Pins eingegangen. Dabei wird beschrieben, dass eine Verbreiterung der Signal-Pins vorgenommen wird, um die Gesamtimpedanz des Steckverbinders zu verkleinern. Eine Erhöhung der Impedanz wird durch einen größeren Pin-Abstand realisiert. Der Artikel offenbart weder genauere Auslegungsvorschriften, noch verweist der Artikel auf solche.

Zudem ist ein Steckverbinder, welcher eine Impedanzanpassung über eine Abstandsvariation zweier zueinander angeordneter Leitungen aus US20140203886A1 bekannt. Der Stecker umfasst dabei eine erste differentielle Übertragungsleitung mit mindestens einem ersten Segment mit einer ersten Impedanz, einem zweiten Segment mit einer zweiten Impedanz und einem dritten Segment mit einer dritten Impedanz, wobei das zweite Segment zwischen dem ersten und dem dritten Segment liegt, und wobei die erste Impedanz sich von der zweiten Impedanz unterscheidet und die zweite Impedanz sich von der dritten Impedanz unterscheidet. Dabei sind die erste, die zweite und die dritte Impedanz und/oder die elektrischen Längen des ersten, des zweiten und des dritten Abschnitts so gewählt, dass sie ein lokales Maximum in den Rückflussdämpfungsspektren der ersten differentiellen Übertragungsleitung ergeben.

Eine Impedanzoptimierung der Übertragungsleitung ist insofern von Relevanz, da sie die Kenngrößen Einfügedämpfung und Rückflussdämpfung wesentlich beeinträchtigen. Die Einfügedämpfung und Rückflussdämpfung sind dabei wichtig für die Bewertung der Qualität von Signalübertragungen.

Die Rückflussdämpfung ist ein Maß für die relative Leistung eines Signals, das von einer Diskontinuität in einer Übertragungsleitung oder einer optischen Faser reflektiert wird. Diese Diskontinuität kann durch eine Fehlanpassung zwischen dem Abschluss oder der Last, die an die Leitung angeschlossen ist und der charakteristischen Impedanz der Leitung verursacht werden. Die Rückflussdämpfung ist das Amplitudenverhältnis zwischen einfallendem und an einer Last oder einem Abschluss zurückreflektierten Signal. Eine gute Signalübertragung wird durch eine hohe Rückflussdämpfung erreicht. Bei dieser Methode wird wenig oder kein Signal an der Quelle reflektiert und mögliche Störungen oder Signalverluste werden gering gehalten.

Neben der Rückflussdämpfung ist die Einfügedämpfung eine wichtige Kenngröße bei der Signalübertragung. Die Einfügedämpfung beschreibt dabei, wie viel Signalenergie verloren geht, wenn ein Signal durch ein Bauteil oder Kabel übertragen wird. Eine hohe Einfügedämpfung führt dazu, dass ein Teil des Signals verloren geht und somit die Qualität der Übertragung beeinträchtigt wird. Eine niedrige Einfügedämpfung bedeutet, dass nur wenig Signalenergie verloren geht, was zu einer besseren Signalübertragung führt.

Um hohe Datenraten in Daten- und Kommunikationskabeln zu erreichen, werden für die Datenübertragung differentielle Leitungen eingesetzt.

Die Impedanz einer differentiellen Leitung, insbesondere eines Leitungsabschnittes wird durch eine Vielzahl an Faktoren beeinflusst. Insbesondere haben die geometrischen Eigenschaften einer Leitung einen Einfluss auf die Impedanz. Diese sind unter anderem die Leiterbahndicke, die Leiterbahnbreite, der Leiterbahnabstand und der Abstand zur GND-Fläche beziehungsweise die Substrathöhe. Des Weiteren ist die Leitungsimpedanz materialabhängig. Unter anderem haben die effektive relative Permittivität und die effektive relative Permeabilität einen Einfluss auf die Impedanz der Leitung.

Die Erfindung hat das Ziel/ die Aufgabe einen elektrischen Verbinder bereitzustellen, der sich durch eine hohe Rückflussdämpfung und eine geringe Einfügedämpfung auszeichnet.

Diese Optimierung wird für einen elektrischen Verbinder mit den Merkmalen des Patentanspruchs 1 gelöst.

Vorteilhafte Ausgestaltungen und Weiterbildungen der Erfindung sind in den abhängigen Ansprüchen angegeben.

Erfindungsgemäß ist demnach ein elektrischer Verbinder für ein Daten- oder Kommunikationskabel mit einem Gehäuse, einer im Gehäuse mindestens teilweise angeordneten Platine, auf welcher erste Kontaktelemente und zweite Kontaktelemente angeordnet sind, wobei jedes der ersten Kontaktelemente mittels einer Leiterbahn mit einem zweiten Kontaktelement elektrisch verbunden ist. Der elektrische Verbinder weist mindestens eine Leiterbahn auf, welche vom ersten Kontaktelement zum zweiten Kontaktelement mindestens drei unterschiedliche Leiterbahnbreiten aufweist, wobei die Leiterbahnbreite ausgehend vom zweiten Kontaktelement zum ersten Kontaktelement bei mindestens drei aufeinanderfolgenden Leiterbahnbreiten stetig oder stufenweise abnehmend ist, wobei der Abstand der beiden Leiterbahnen einer differentiellen Leitung über jeden der mindestens drei aufeinanderfolgenden Leiterbahnbreite zumindest teilweise gleichbleibend ausgebildet ist.

In der vorliegenden Erfindung ist eine verbesserte Leitungsbahnkonfigurationsvorschrift offenbart, um die Rückflussdämpfung und Einfügedämpfung zu optimieren. Dies erfolgt vornehmlich durch eine Optimierung der Leiterbahnbreite und damit einer Optimierung der Impedanz einer differentiellen Leitung. Der Abstand der beiden Leiterbahnen einer differentiellen Leitung wird dabei über einen weiten Bereich gleich belassen. Dadurch verringert sich die Anzahl der Freiheitsgrade, welche für eine Impedanzoptimierung der differentiellen Leitung zur Verfügung stehen. Dadurch fällt die Auslegung der Leiterbahnkonfiguration schneller und kostengünstiger aus. Zudem ist sichergestellt, dass der Mindestabstand zwischen zwei benachbart verlaufenden Leitungen gewährleistet ist.

In einer besonders bevorzugten Ausgestaltung der Erfindung sind die Leiterbahnen als differentielle Leitungen ausgebildet, wobei die differentielle Leitung zwei zumindest teilweise zueinander parallel verlaufende Leiterbahnen aufweist. Gegenüber ungleichförmigen oder single-ended Leitungen besitzen differentielle Leitungen einige Vorteile. Differentielle Leitungen besitzen eine bessere Störfestigkeit. Sie sind weniger anfällig für externe elektromagnetische Störungen. Insbesondere bei höheren Frequenzen besitzen differentielle Leitungen eine höhere Signalintegrität als single-ended Leitungen. Unter anderem werden Signalreflexionen und Interferenzen minimiert. Hierdurch wird der Signaltransport effizienter, wodurch der Energieverbrauch für dieselbe Datenübertragung geringer ausfällt.

Eine differentielle Leitung kann als Microstrip-Leitung ausgeführt werden. Bei dieser Ausgestaltung der Erfindung werden die beiden Leitungen einer differentiellen Leitung typischerweise auf der Oberseite einer Leiterplatte ausgebildet, wohingegen die dazugehörige Massefläche beispielsweise auf der Unterseite der Leiterplatte ausgebildet ist. Zumeist sind die Leitungen der differentiellen Leitung und die Massefläche elektrisch isoliert. Als Isolationsmaterial kommen Epoxidharze, Polymid, Fr-4 und weitere Materialien in Frage. Vorteilhaft an einer Microstrip-Leitung sind die einfache Herstellung und die geringen Kosten. Zum Anschluss elektrischer Verbinder, in welchen differentielle Leitungen zur Datenübermittelung verwendet werden, werden Twisted-Pair-Kabel verwendet.

Erfindungsgemäß ist der Abstand der beiden Leiterbahnen einer differentiellen Leitung mindestens annähernd gleichbleibend ausgebildet. Durch den gleichbleibenden Leiterbahnabstand ist gewährleistet, dass die erforderlichen Luft- und Kriechstrecken eingehalten werden.

Der der Erfindung zugrundeliegende elektrische Verbinder ist bevorzugt als Anschlussdose für RJ45-Stecker oder als RJ45-Stecker ausgebildet. Eine bestimmte Isolationsfestigkeit der Leitungen zueinander für RJ45 Steckverbinder unterliegt keiner Norm, weswegen auf die Norm DIN EN IEC 60664-1 Bezug genommen wird, in welcher die Isolationskoordination für Betriebsmittel in Niederspannungs-Stromversorgungssystemen beschrieben ist. Der Mindestabstand zwischen den benachbarten Kontakten eines RJ45 Steckverbinders ist in der Norm DIN EN 60603-7:2019-11 vorgegeben.

Gemäß einer vorteilhaften Weiterbildung der Erfindung weist der Impedanzwert des ersten Kontaktelements einen größeren Wert auf, als der Impedanzwert des zweiten Kontaktelements.

In einer bevorzugten Ausgestaltung der Erfindung ist das zweite Kontaktelement als Schneidklemme, welche auch IDC-Klemme genannt wird, ausgebildet. Vorteile von Schneidklemmen sind, dass sie sehr einfach zu installieren sind. Die Schneidklemmen werden auf das Kabel gedrückt oder vice versa, sodass die Kontaktstellen sich durch die Isolierung schneiden und eine elektrische Verbindung zwischen Leitung und Schneidklemme hergestellt wird. Die Anschlusszeit wird dadurch erheblich reduziert, was zu einer Kostenreduzierung bei der Installation führt. Ein weiterer Vorteil ist, dass bei der Kontaktierung mittels Schneidklemmen in der Regel keine Beschädigung des Kabels auftritt. Die elektrischen Eigenschaften am Kabel bleiben erhalten, sodass ein Brechen oder Korrodieren an einer beschädigten Stelle nahezu ausgeschlossen ist. Zudem ist die Verbindung mit Schneidklemmen äußerst zuverlässig, da Schneidklemmen eine große Kontaktfläche zwischen Leitung und Schneidklemmen aufweisen. Des Weiteren sind Schneidklemmen in verschiedensten Ausführungen bekannt, sodass eine hohe Kompatibilität gegeben ist.

Vorteilhafterweise ist das erste Kontaktelement als gebogener Steckkontakt ausgebildet.

Eine weitere bevorzugte Ausgestaltung der Erfindung sieht vor, dass die Impedanz des Bereichs der differentiellen Leitung, welcher dem zweiten Kontaktelement, also beispielsweise dem anzuschließenden Kabel zugewandt, am nächsten zugeordnet ist, den geringsten Impedanzwert der differentiellen Leitung aufweist, wobei die Impedanz des Bereichs der differentiellen Leitung, welcher dem ersten Kontaktelement, also beispielsweise dem Steckgesicht des elektrischen Verbinder zugewandt, am nächsten zugeordnet ist, den größten Impedanzwert der differentiellen Leitung aufweist.

Der Impedanzwert einer differentiellen Leitung lässt sich in erster Annäherung durch die Leitungsbeläge bestimmen. Bei hohen Frequenzen und einer verlustlosen idealen Leitung berechnet sich die Impedanz aus der Wurzel des Quotienten des induktiven und des kapazitiven Leitungsbelags. Die Leitungsbeläge hängen unteranderem von geometrischen und materialabhängigen Größen ab. Beispielsweise haben die geometrischen Parameter wie die Leiterbahndicke, Leiterbahnbreite, Leiterbahnabstand und die Substrathöhe einen Einfluss. Die Impedanz hängt zudem von Materialeigenschaften wie der effektiven relativen Permeabilität und der effektiven relativen Permittivität ab. Umso breiter die Leiterbahnbreite einer Leitung ist, umso kleiner ist die Impedanz der Leitung.

Die Anpassung der differentiellen Leitungsimpedanz bietet die Möglichkeit, Bereiche unterschiedlicher Impedanzen zu definieren und diese Bereiche individuell zu optimieren. Schneidklemmen besitzen aufgrund ihrer großen Schneidfläche eine geringere Impedanz als beispielsweise ein Kontaktsatz eines RJ45-Steckers. Es ist daher vorteilhaft, dass Leiterbahnabschnitte, welche nahe der Schneidklemmen liegen, eine geringere Impedanz aufweisen, als Leiterbahnabschnitte, welche näher an dem Kontaktsatz des RJ45-Steckers liegen. Dies hat zur Folge, dass die Leiterbahnbreiten nahe der Schneidklemmen in bevorzugter Weise breiter ausfallen, als Leiterbahnbreiten nahe eines Kontaktsatzes eines RJ45-Steckers.

Gemäß einer anderen vorteilhaften Weiterbildung sind auf der Platine acht erste Kontaktelemente und acht zweite Kontaktelemente angeordnet. Vorteilhafterweise sind dabei vier differentielle Leitungen auf der Platine ausgebildet.

In einer weiteren günstigen Ausgestaltung ist der Leiterbahnbreite bei einer stufenweisen Abnahme der Leiterbahnbreite zwischen zwei Stufen mindestens abschnittsweise konstant ausgebildet.

Vorteilhafterweise ist die Leiterbahnbreite zwischen der stufenweisen Abnahme der Leiterbahnbreite kontinuierlich abnehmend ausgebildet, wobei die Leiterbahnbreite an der Stelle der Leiterbahn, welche dem zweiten Kontaktelement am nächsten zugeordnet ist, am breitesten ist. Durch die kontinuierliche Abnahme der Leiterbahnbreite innerhalb eines Verbindungsabschnittes kann eine feinere Optimierung der Leitungsimpedanz erfolgen.

Gemäß einer anderen vorteilhaften Weiterbildung der Erfindung weist die mindestens eine Leiterbahn in den Endbereichen der Leiterbahn eine annähernd gleichbleibende Leiterbahnbreite auf.

Vorteilhafterweise ist jede Leiterbahn jeweils über ein Kontaktpad mit dem ersten Kontaktelement und ein weiteres Kontaktpad mit dem zweiten Kontaktelement verbunden.

Hier und im Folgenden sind Linien und Ebenen, welche deckungsgleich oder versetzt zueinander verlaufen und dieselbe Steigung im Raum aufweisen, vorzugsweise unter dem Begriff der Parallelität zusammenzufassen.

Im Folgenden werden Ausführungsbeispiele der Erfindung anhand von Figuren erläutert. Es zeigen:
- Fig. 1: eine perspektivische Ansicht einer Anschlussdose in Explosionsdarstellung mit Gehäuseoberteil, Leiterplatte und Gehäuseunterteil,
- Fig. 2: eine perspektivische Ansicht einer Leiterplatte von Fig. 1 einer Anschlussdose, welche mit Schneidklemmen und einer Buchse bestückt ist,
- Fig. 3: eine perspektivische Ansicht einer Leiterplatte von Fig. 1 einer Anschlussdose,
- Fig. 4: ein differentielles Leitungspaar der Anschlussdose von Fig. 3,
- Fig. 5: eine perspektivische Ansicht eines Steckverbinders in Explosionsdarstellung mit Gehäuseoberteil, Leiterplatte und Gehäuseunterteil,
- Fig. 6: eine perspektivische Ansicht einer mit Schneidklemmen bestückten Leiterplatte von Fig. 5 eines Steckverbinders, mit eingesetztem Trägerelement,
- Gig. 7: ein differentielles Leitungspaar eines Steckverbinders von Fig. 6.

In den nachfolgenden Figuren bezeichnen gleiche Bezugszeichen gleiche Teile mit gleicher Bedeutung.

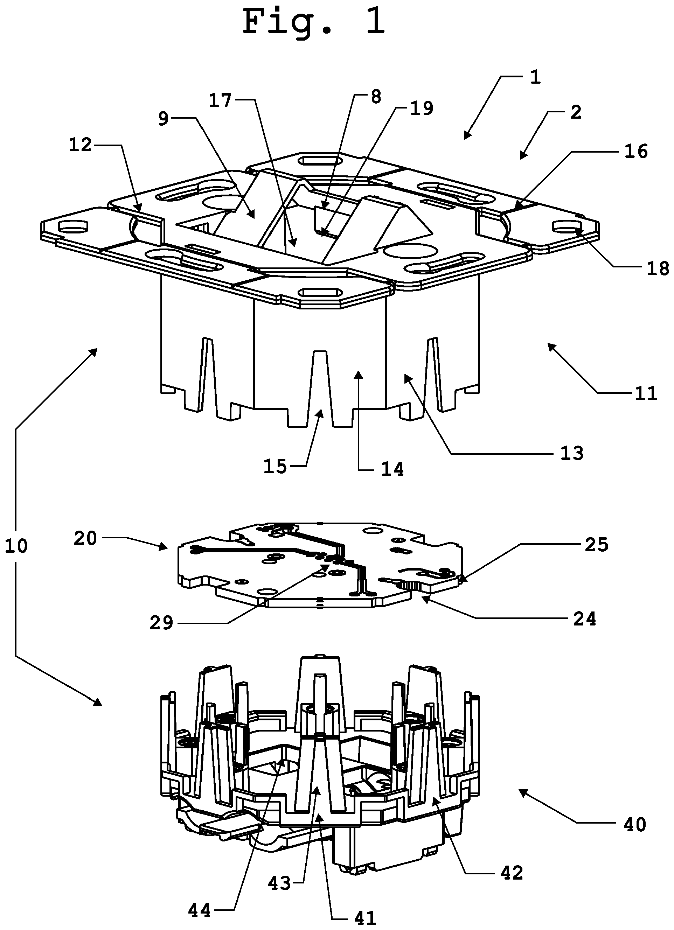

Fig. 1 zeigt einen elektrischen Verbinder 1 in Form einer Anschlussdose 2. Die Anschlussdose 2 weist ein Gehäuse 10 auf, welches ein Gehäuseoberteil 11 und ein Gehäuseunterteil 40 aufweist.

Das Gehäuseunterteil 40 weist eine achteckige Grundplatte 42 auf. An jeder Seite 41 der achteckigen Grundplatte 42 sind mittig Führungselemente 43 angebracht, welche in Richtung Gehäuseoberteil 11 zeigen. An der zum Gehäuseoberteil 11 abgewendeten Seite der Grundplatte 42 sind Kabeleingangsöffnungen 44 ausgebildet, durch welche eines oder mehrere Kabel in das Gehäuse 10 einführbar sind. Die Grundplatte 42 des Gehäuseunterteils 40 kann auch rund oder vieleckig insbesondere quadratisch oder rechteckförmig ausgebildet sein.

Das Gehäuseoberteil 11 ist wannenartig ausgebildet. Das Gehäuseoberteil 11 weist eine Deckenfläche 12, mit einer in Richtung des Gehäuseunterteils 40 ausgerichteten Gehäuseumwandung 13 auf. Die Gehäuseumwandung 13 ist symmetrisch achteckig ausgebildet. Die Deckenfläche 12 weist im Randbereich 16 Aussparungen 18 auf, um Haltemittel aufzunehmen, durch welche die Anschlussdose 2 beispielsweise an einer Wand montiert werden kann. In der Mitte der Deckenfläche 12 ist eine Erhebung 9 ausgebildet, welche einen Freiraum 17 freigibt, welcher im zusammengesetzten Zustand eine Buchse 50 aufnimmt. Die Erhebung 9 bildet zwei Teilkörper mit einem trapezförmigen Querschnitt aus, welche über einen Mittelsteg 8 miteinander verbunden sind. Zwischen den beiden Teilkörpern bildet sich eine Freifläche 19 aus.

Die Freifläche 19 weist gegenüber der Deckenfläche 12 einen Winkel aus. Die Freifläche 19 kann ebenfalls gegenüber der Deckenfläche 12 senkrecht angeordnet sein. Die Freifläche 19 kann gegenüber der Deckenfläche 12 auch waagrecht angeordnet sein. Die Gehäuseumwandung kann zudem rund oder vieleckig, insbesondere quadratisch oder rechteckförmig ausgebildet sein.

Die Gehäuseumwandung 13 des Gehäuseoberteils 11 weist acht Seitenflächen 14 auf, wobei jede Seitenfläche 14 eine Führungsausnehmung 15 aufweist. Die Führungsausnehmungen 15 des Gehäuseoberteils 11 sind so ausgebildet, dass diese im zusammengesetzten Zustand die Führungselemente 43 des Gehäuseunterteils aufnehmen. Das Gehäuseoberteil 11 und das Gehäuseunterteil 40 sind so ausgebildet, dass das Gehäuseoberteil 11 an dem Gehäuseunterteil 40 in mehreren, gegeneinander um eine gedachte Gehäusemittelachse gedrehten Stellungen festlegbar ist.

Das Gehäuseoberteil 11 und das Gehäuseunterteil 40 des Gehäuses 10 sind vorzugsweise aus einem leitenden Material beispielsweise aus Blech ausgebildet. Die Anschlussdose 2 weist durch das leitende Material eine elektrische Schirmung auf. Die elektromagnetische Verträglichkeit der Anschlussdose 2 verbessert sich dadurch signifikant. Zudem wird die Störaussendung der Anschlussdose 2 und Beeinflussung durch die Anschlussdose 2 gegenüber anderen elektronischen Geräten verringert.

Die Gehäuseumwandung 13 des Gehäuseoberteils 11 weist in einer bevorzugten Ausgestaltung der Erfindung dieselbe Gestalt auf, wie die Grundplatte 42 des Gehäuseunterteils 41.

In dem Gehäuse 10 der Anschlussdose 2 ist eine Platine 20 angeordnet. Die Platine 20 kann auch zumindest teilweise in dem Gehäuse 10 der Anschlussdose 2 angeordnet sein. Die Platine 20 besitzt die Form eines Achtecks. Die Platine 20 kann zudem die Form eines Vielecks, eines Ovals oder eines Kreises besitzen. Die Platine 20 weist an mindestens einer Seite 25 der Platine 20 eine Einbuchtung 24 auf. Die Platine 20 kann zudem an zwei gegenüberliegenden Seiten 25 Einbuchtungen 24 aufweisen. Die mindestens eine Einbuchtung 24 ist derart gestaltet, dass die Platine 20 in das Gehäuseunterteil 40 einsetzbar ist und in mindestens einer Raumrichtung mechanisch fixiert wird. Die Platine 20 ist vorzugsweise als zweilagige Platine 20 ausgebildet. Die Platine 20 kann auch mehr als zwei Lagen besitzen. In bevorzugter Weise weist die Platine 20 eine gerade Anzahl an Platinenlagen auf.

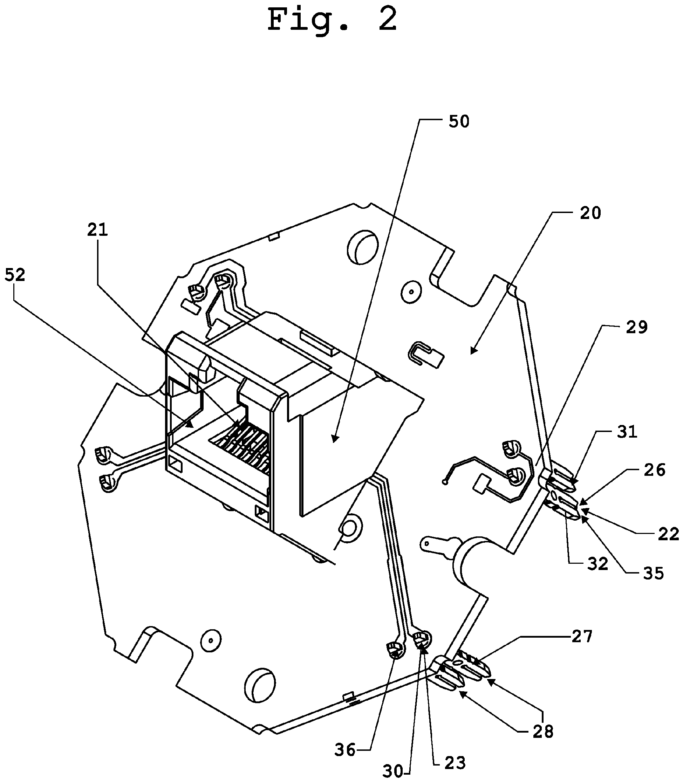

In Fig. 2 ist die aus Fig. 1 gezeigte Platine 20 abgebildet. Die Platine 20 ist auf der zum Gehäuseoberteil 11 zugewandten Seite mit einer Buchse 50 bestückt. Im zusammengesetzten Zustand füllt die Buchse 50 den Freiraum 17 des Gehäuseoberteils 11 aus. Die Buchse 50 enthält erste Kontaktelemente 21, welche mit den Gegenkontakten eines Gegensteckers (nicht gezeigt) eine elektrische Verbindung zwischen Gegenstecker und Anschlussdose 2 herstellen. Vorzugsweise weist die Anschlussdose für jeden Gegenstecker, der angeschlossen wird, acht erste Kontaktelemente 21 auf. Die ersten Kontaktelemente 21 sind in einer Reihe oder versetzt zueinander angeordnet. Die ersten Kontaktelemente 21 der Buchse 50 weisen jeweils mindestens einen Fuß auf. Der jeweils eine Fuß des einen ersten Kontaktelementes 21 in der Buchse 50, ist durch eine erste Kontaktöffnung 34 durchführbar. Der Fuß eines ersten Kontaktelementes 21 einer Buchse 50 wird mittels einer Lötung mechanisch auf der Platine 20 fixiert und elektrisch mit der Platine 20 kontaktiert.

Die Buchse 50 kann zudem als SMD Bauteil direkt auf der dem Gehäuseoberteil 11 zugewandten Seite aufgelötet und dadurch mechanisch auf der Platine 20 fixiert und elektrisch mit der Platine 20 kontaktiert werden.

In einer anderen Ausgestaltung der Erfindung sind mindestens zwei Buchsen 50 auf der Platine 20 montierbar. Die Buchse 50 weist eine Ausgangsöffnung 52 auf, in welche ein passender Gegenstecker einführbar ist. Die Ausgangsöffnung 52 der Buchse 50 ist in einem Winkel zur Deckenfläche 12 angeordnet. Die Ausgangsöffnung 52 der Buchse 50 kann auch senkrecht oder waagrecht zur Deckenfläche 12 angeordnet sein.

Auf der Platine 20 sind erste Kontaktelemente 35 angeordnet. Die erste Kontaktelemente 35 sind bevorzugt als Schneidklemmen 26 ausgebildet. Die Schneidklemmen 26 weisen einen Stift 36 auf. Der Stift 36 ist in eine zweite Kontaktöffnung 33 der Platine 20 einsetzbar. Der durch die Kontaktöffnung 33 eingesetzte Stift 36 wird mit dem dazugehörigen ersten Kontaktpad 23 verlötet. Durch die Lötung ist die Schneidklemme 26 mit der Platine 20 elektrisch kontaktiert. Die Lötung bewirkt, dass die Schneidklemme 26 mit der Platine 20 mechanisch und elektrisch verbunden ist. Der Stift 36 einer Schneidklemme 26 kann mittels einer Pressung mechanisch und elektrisch auf der Platine 20 kontaktiert werden.

Die Schneidklemmen 26 zeigen in Richtung des Gehäuseunterteils 40. Die Schneidklemmen 26 weisen eine Schneidklemmenfläche 27 auf. Die Schneidklemmen 26 sind paarweise auf der Platine 20 angeordnet. Die Schneidklemmen 26 sind im Randbereich, vorzugsweise in einer der Eckpunkte 29 der Platine 20 angeordnet. Die Schneidklemmen 26 können ebenfalls nahe des Platinenmittelpunktes 29 angeordnet sein. Die Schneidklemmenflächen 27 eines Schneidklemmenpaares 28 verlaufen parallel zueinander. Die Schneidklemmen 26 können auch so gestaltet sein, dass die Schneidklemmenflächen 27 eines Schneidklemmenpaares 28 einen Winkel zueinander aufweisen. Zudem können die Schneidklemmen 26 auch so gestaltet sein, dass die Schneidklemmenflächen 27 eines Schneidklemmenpaares 28 senkrecht aufeinander stehen.

Die Schneidklemmen 26 weisen in der Schneidklemmenfläche 27 eine Ausnehmung 31 auf, sodass sich zwei Stäbe 32 ausbilden. Beim Zusammensetzen der Anschlussdose 2 werden die isolierten Kabeladern (nicht zu sehen) durch die Schneidklemmen 26 abisoliert und es stellt sich eine elektrische Verbindung zwischen den Kabeladern und den Schneidklemmen 26 ein.

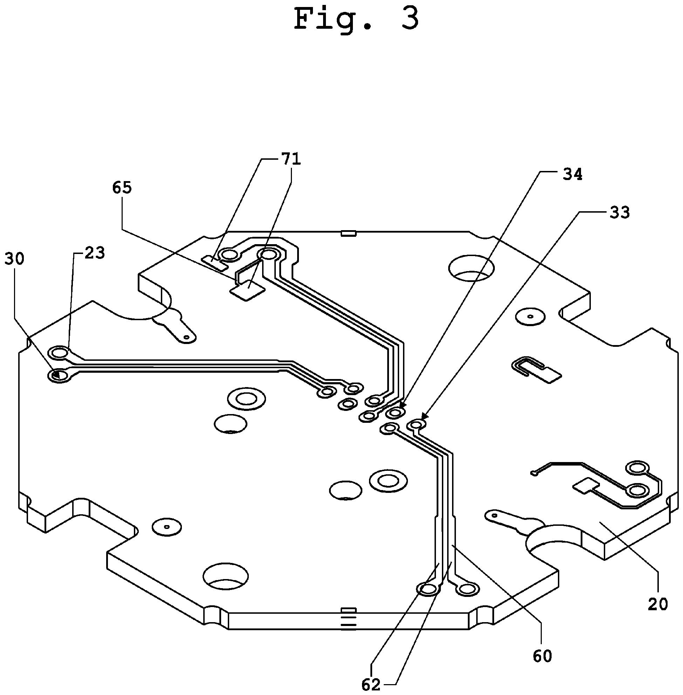

In Fig. 3 ist die Platine 20 aus Fig. 1 in einer perspektivischen Ansicht abgebildet. Es ist die dem Gehäuseoberteil 11 zugewandte Seite der Platine 20 zu sehen.

Auf der Platine 20 sind acht Leiterbahnen 60 ausgebildet, wobei jeweils zwei Leiterbahnen 60 eine differentielle Leitung 62 ausbilden. Die beiden Leiterbahnen 60 mit der Kontaktbelegung eins und zwei bilden eine differentielle Leitung 62. Die Leiterbahnen 60 mit der Kontaktbelegung drei und sechs bilden eine zweite differentielle Leitung 62. Die Leiterbahnen 60 mit der Kontaktbelegung vier und fünf bilden eine dritte differentielle Leitung 62. Die Leiterbahnen 60 mit der Kontaktbelegung sieben und acht bilden eine vierte differentielle Leitung 62.

Auf der dem Gehäuseoberteil 11 zugewandten Seite verlaufen drei der vier differentiellen Leitungen 62. Auf der dem Gehäuseunterteil 40 zugewandten Seite verläuft eine der vier differentiellen Leitungen 62, nämlich die zu der Kontaktbelegung drei und sechs. Es kann auch mindestens eine der differentiellen Leitung 62 auf der dem Gehäuseoberteil 11 zugewandten Seite der Platine 20 verlaufen. Zudem kann mindestens eine der differentiellen Leitung 60 auf der dem Gehäuseunterteil 40 zugewandten Seite der Platine 20 verlaufen. In einer anderen Ausgestaltung der Erfindung verlaufen alle differentiellen Leitungen 62 entweder auf der dem Gehäuseoberteil 11 zugewandten Seite oder dem Gehäuseunterteil 40 zugewandten Seite. In einer anderen Ausgestaltung der Erfindung in welcher eine mehrlagige Platine 20 eingesetzt wird, verlaufen die differentiellen Leitungen 62 sowohl in einer der mittleren Lagen, als auch auf der dem Gehäuseoberteil 11 und/oder der dem Gehäuseunterteil 40 zugewandten Seite der Platine 20. Die differentiellen Leitungen 62 können auch nur ausschließlich in einer der mittleren Lagen der mehrlagigen Platine 20 verlaufen.

Als Verbindungsglied zwischen einem der ersten Kontaktelemente 21 und einer differentiellen Leitung 62 ist ein erstes Kontaktpad 33 geschaltet. Die ersten Kontaktpads 33 bilden einen Kreisring aus, wobei die zweiten Kontaktöffnungen 30 dem Innenradius des Kreisrings entsprechen. Eines der ersten Kontaktpads 33 kann ebenfalls eine ovale oder vieleckige, insbesondere quadratische oder rechteckförmige Form aufweisen.

Als Verbindungsglied zwischen einem der zweiten Kontaktelemente 22 und einer differentiellen Leitung 62 ist ein zweites Kontaktpad 23 geschaltet. Die zweiten Kontaktpads 23 bilden einen Kreisring aus, wobei die ersten Kontaktöffnungen 34 dem Innenradius des Kreisrings entsprechen. Eines der zweiten Kontaktpads 23 kann ebenfalls eine ovale oder vieleckige, insbesondere quadratische oder rechteckförmige Form aufweisen.

An den zweiten Kontaktpads 23, welche die Kontaktbelegung vier und fünf aufweisen sind neben der differentiellen Leitung 62, jeweils eine Stichleitung 65 angeschlossen. Die jeweilige Stichleitung 65 ist mit einer Kondensatorplatte 71 verbunden. Auf der gegenüberliegenden Seite der Platine 20 ist eine zweite Kondensatorplatte 71 angeordnet, welche über eine andere Stichleitung 65 mit einem zweiten Kontaktpad 23 angeschlossen ist. Die beiden Kondensatorplatten 71 bilden zusammen einen Kondensator aus. Die Stichleitungen 65 eines Kondensators können zudem mit einer differentiellen Leitung 65 verbunden sein. Die ersten Kontaktpads 33 und zweiten Kontaktpads 23 bilden beide einen Kreisring aus, wobei die ersten Kontaktöffnungen 34 und zweiten Kontaktöffnungen 30 den Innenradius des jeweiligen Kreisrings ausbilden.

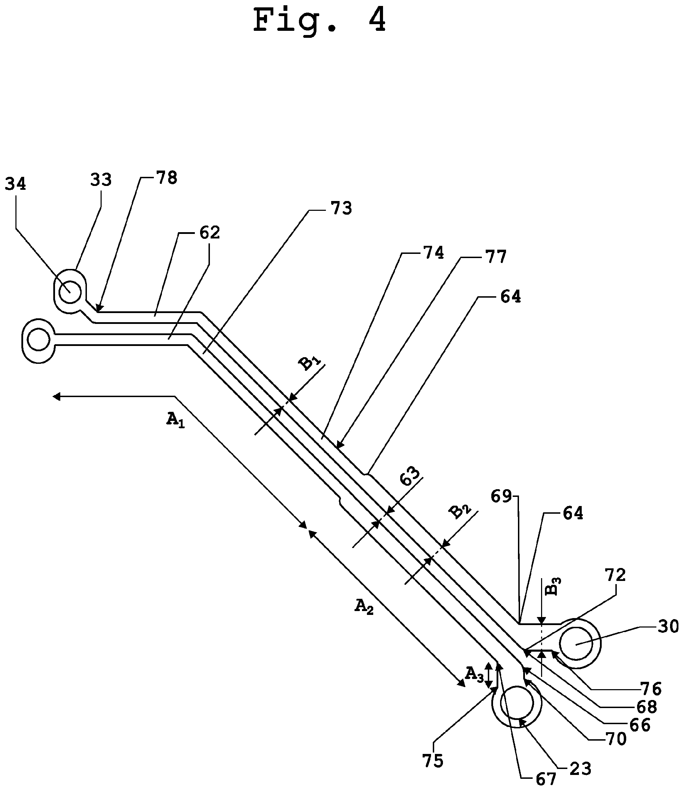

In Fig. 4 ist die in Fig. 3 dargestellte eine differentielle Leitung 62 der Kontaktbelegung eins und zwei vergrößert abgebildet. Eine Leiterbahn 60 der differentiellen Leitung 62 ist mit einem ersten Kontaktpad 23 und einem zweiten Kontaktpad 33 verbunden. Eine Leiterbahn 60 der differentiellen Leitung 62 weist drei Leitungsabschnitte A1-A3 auf. Die Leiterbahn 60 einer differentiellen Leitung 62 kann auch mehr als drei Leitungsabschnitte A1-A3 aufweisen. Die Leitungsabschnitte A1-A3 unterscheiden sich vorzugsweise in der unterschiedlichen Ausgestaltung der Leiterbahnbreite B1-B3. Die differentielle Leitung 62 weist eine erste Leiterbahn 73 und eine zweite Leiterbahn 74 auf.

Zwischen dem ersten Leitungsabschnittes A1 der ersten Leiterbahn 73 einer differentiellen Leitung 62 und dem zweiten Kontaktpad 23 einer ersten Leiterbahn 73 der differentiellen Leitung 62 ist ein erster Kontaktbereich 75 ausgebildet. Der Beginn des ersten Leiterbahnabschnitts A1 der ersten Leiterbahn 73 der differentiellen Leitung 62 ist eine auf dem ersten Kontaktpunkt 70 orthogonal zur Leiterbahnwand 77 verlaufenden gedachten Linie. Das Ende des ersten Leiterbahnquerschnitts A1 der ersten Leiterbahn 73 der differentiellen Leitung 62 ist eine auf dem zweiten Abknickpunkt 67 orthogonal zur Leiterbahnwand 77 verlaufenden gedachten Linie.

Innerhalb des Leiterbahnabschnitts A1 der ersten Leiterbahn 73 der differentiellen Leitung 62 weist die erste Leiterbahnbreite B1 einen unstetigen Verlauf auf. Vom Beginn des ersten Leiterbahnquerschnitts A1 einer ersten Leiterbahn 73 der differentiellen Leitung 62 bis zu einer auf dem ersten Abknickpunkt 66 orthogonal zur Leiterbahnwand 77 stehenden gedachten Linie ist die Leiterbahnbreite B1 gleichbleibend ausgebildet. Ab der auf dem ersten Abknickpunkt 66 orthogonal zur Leiterbahnwand 77 stehenden gedachten Linie bis zum Ende des Leiterbahnabschnittes A1 der ersten Leiterbahn 73 verjüngt sich die Leiterbahnbreite B1 der ersten Leiterbahn 73 der differentiellen Leitung 62.

Zwischen dem ersten Leiterbahnabschnitt A1 einer zweiten Leiterbahn 74 der differentiellen Leitung 62 und dem zweiten Kontaktpad 23 einer zweiten Leiterbahn 74 der differentiellen Leitung 62 ist ein zweiter Kontaktbereich 76 ausgebildet. Der Beginn des ersten Leiterbahnabschnitts A1 einer zweiten Leiterbahn 73 der differentiellen Leitung 62 ist eine auf dem zweiten Kontaktpunkt 72 orthogonal zur Leiterbahnwand 77 verlaufenden gedachten Linie. Das Ende des ersten Leiterbahnquerschnitts A1 einer zweiten Leiterbahn 74 der differentiellen Leitung 62 ist eine auf dem vierten Abknickpunkt 69 orthogonal zur Leiterbahnwand 77 verlaufenden gedachten Linie.

Innerhalb des Leiterbahnabschnitts A1 einer zweiten Leiterbahn 74 der differentiellen Leitung 62 weist die erste Leiterbahnbreite B1 einen unstetigen Verlauf auf. Vom Beginn des ersten Leiterbahnquerschnitts A1 einer zweiten Leiterbahn 74 der differentiellen Leitung 62 bis zu einer auf dem dritten Abknickpunkt 68 orthogonal zur Leiterbahnwand 77 stehenden gedachten Linie ist die Leiterbahnbreite B1 gleichbleibend ausgebildet. Ab der auf dem dritten Abknickpunkt 68 orthogonal zur Leiterbahnwand 77 stehenden gedachten Linie bis zum Ende des Leiterbahnabschnittes A1 der zweiten Leiterbahn 74 verjüngt sich die Leiterbahnbreite B1 der zweiten Leiterbahn 74 der differentiellen Leitung 62.

Der Abstand 63 der Leiterbahnen 60 der differentiellen Leitung 62 ist innerhalb des ersten Leiterbahnabschnittes A1 teilweise gleichbleibend ausgebildet. Der teilweise gleichbleibend ausgebildete Abstand 63 der Leiterbahnen 60 der differentiellen Leitung 62 bildet sich zwischen der auf dem zweiten Abknickpunkt 67 orthogonal zur Leiterbahnwand 77 stehenden gedachten Linie und einer gedachten Linie, welche orthogonal auf der Leiterbahnwand 77 einer ersten Leiterbahn 73, welche der zweiten Leiterbahn 74 der differentiellen Leitung 62 näher angeordnet ist und den dritten Abknickpunkt 68 schneidet, aus.

Der erste Leiterbahnabschnitt A1 kann zudem über den gesamten ersten Leiterbahnabschnitt A1 einen gleichbleibenden Abstand 63 der beiden Leiterbahnen 60 der differentiellen Leitung 62 aufweisen. Die erste Leiterbahnbreite B1 kann auch über den gesamten Leiterbahnabschnitt A1 die gleiche Leiterbahnbreite B1 aufweisen. Die erste Leiterbahnbreite B1 kann über den gesamten Leiterbahnabschnitt A1 eine veränderliche Leiterbahnbreite B1 aufweisen. Die erste Leiterbahnbreite B1 ist, ausgehend von den Schneidklemmen 26, stets verjüngend ausgebildet.

Der Übergang zwischen dem ersten Leiterbahnabschnitt A1 und dem zweiten Leiterbahnabschnitt A2 erfolgt abrupt, sodass sich Stufen 64 zwischen den beiden Leiterbahnabschnitten (A1-A2) ausbilden. Der Übergang zwischen dem ersten Leiterbahnabschnitt A1 und dem zweiten Leiterbahnabschnitt A2 kann fließend ausgebildet sein.

Der zweite Leiterbahnabschnitt A2 ist zwischen dem ersten Leiterbahnabschnitt A1 und dem dritten Leitungsabschnitt A3 angeordnet. Der zweite Leitungsabschnitt A2 weist eine Leiterbahnbreite B2 auf, welche mindestens dünner ist als die Leiterbahnbreite B1 des ersten Leiterbahnabschnittes A1. Der Abstand 63 der Leiterbahnen 60 einer differentiellen Leitung 62 ist über den zweiten Leiterbahnabschnitt A2 durchgehend gleichbleibend ausgebildet. In einer anderen Ausbildung der Erfindung ist der Abstand der Leiterbahnen 60 einer differentiellen Leitung 62 über den zweiten Leiterbahnabschnitt A2 zumindest teilweise gleichbleibend ausgebildet.

Der Übergang zwischen dem zweiten Leiterbahnabschnitt A2 und dem dritten Leiterbahnabschnitt A3 erfolgt abrupt, sodass sich Stufen 64 zwischen den beiden Leiterbahnabschnitten (A2-A3) ausbilden. Der Übergang zwischen dem zweiten Leiterbahnabschnitt A2 und dem dritten Leiterbahnabschnitt A3 kann fließend ausgebildet sein.

Der dritte Leiterbahnabschnitt A3 weist eine dritte Leiterbahnbreite B3 auf, welche mindestens dünner ausgebildet ist als die Leiterbahnbreite B1 und die zweite Leiterbahnbreite B2. Der dritte Leiterbahnabschnitt A3 grenzt an den zweiten Leiterbahnabschnitt A2 auf einer Seite an. Die beiden Leiterbahnen 60 der differentiellen Leitung 62 weisen vom Grenzbereich mit dem zweiten Leiterbahnabschnitt A2 bis zum fünften Knickpunkt 78, welcher an der zweiten Leiterbahn 74 ausgebildet ist, einen gleichbleibenden Abstand 63 der Leiterbahnen 60 der differentiellen Leitung 62 zueinander auf. Ab dem fünften Knickpunkt 78 vergrößert sich der Abstand 63 der beiden Leiterbahnen 60 der differentiellen Leitung 62. Die Leiterbahnbreite B3 des Leiterbahnabschnittes A3 weist stets eine gleichbleibende Breite auf.

Die dritte Leiterbahnbreite B3 des Leiterbahnabschnitt A3 kann ebenfalls eine veränderliche Breite aufweisen. Die dritte Leiterbahnbreite B3 ist, ausgehend von der Grenze zum zweiten Leiterbahnabschnitt A2, verjüngend ausgebildet. Der Abstand 63 der Leiterbahnen 60 der differentiellen Leitung 62 zueinander durchgehend kann zudem gleichbleibend ausgebildet sein.

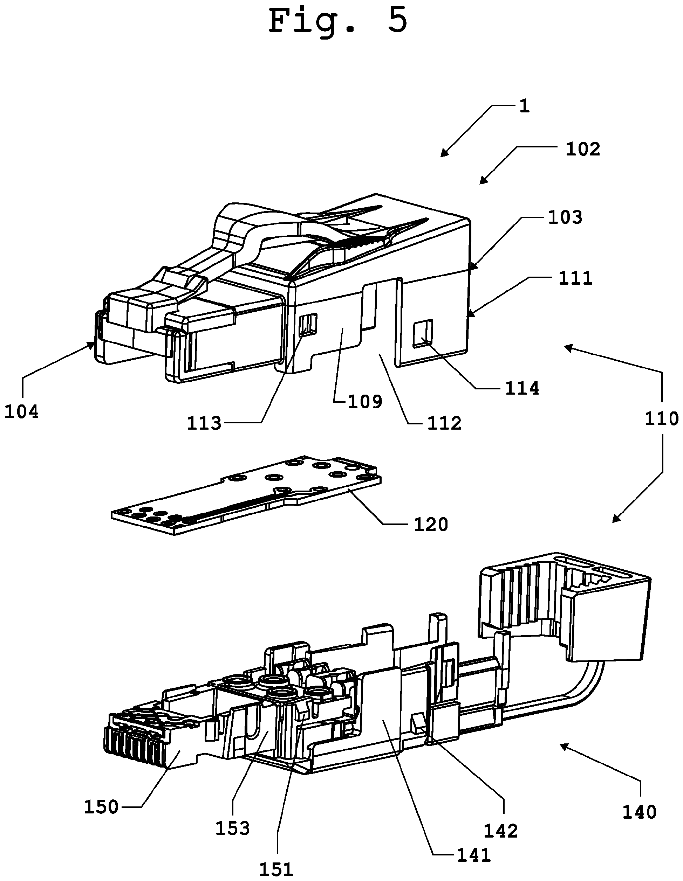

In Fig. 5 ist ein elektrischer Verbinder 1, der als Steckverbinder 102 ausgebildet ist, in Explosionsdarstellung abgebildet. Der Steckverbinder 102 besitzt eine Anschlussseite 103 und eine Steckseite 104.

Der Steckverbinder 102 weist ein Gehäuse 110 auf, welches ein Gehäuseoberteil 111 und ein Gehäuseunterteil 140 aufweist. Das Gehäuseoberteil 111 ist in das Gehäuseunterteil 140 einführbar. Hierfür weist das Gehäuseoberteil 111 eine Aussparung 112 und das Gehäuseunterteil ein Führungselement 141 auf. Das Führungselement 141 und die Aussparung 112 besitzen eine L-förmige Form. Das Führungselement 141 und die Aussparung können zudem die Form eines Vielecks insbesondere eines Rechtecks oder Quadrates besitzen.

Das Gehäuseoberteil weist auf jeder Gehäuseseite 109 ein vorderes Haltemittel 113 und ein hinteres Haltemittel 114 auf. Das für das vordere Haltemittel komplementäre Haltmittel 151 ist am Trägerelement 150 auf beiden Trägerelementseiten 153 angeordnet. Das Trägerelement 150 ist in das Gehäuseunterteil 140 einsetzbar. Das Trägerelement 150 ist aus einem nicht-leitenden Material ausgebildet, vorzugsweise aus Kunststoff. Das Gehäuse 110 des Steckverbinders 102 ist vorzugsweise aus einem leitenden Material beispielsweise aus Blech ausgebildet.

Das vordere Haltemittel 113 des Gehäuseoberteils 111 ist als Aussparung ausgebildet. Das hintere Haltemittel 114 des Gehäuseoberteils 111 ist ebenfalls als Aussparung ausgebildet. Das Haltemittel 151, welches am Trägerelement 150 angeordnet ist, ist als Rastnase ausgebildet. Im zusammengesetzten Zustand greift die Rastnase, welche am Trägerelement 150 angeordnet ist, in das komplementäre vordere Haltemittel 113 des Gehäuseoberteils 111 ein. Das Haltemittel 142, welches am Gehäuseunterteil 140 angeordnet ist, ist als Rastnase ausgebildet. Im zusammengesetzen Zustand greift diese Rastnase in das komplementäre hintere Haltemittel 114 ein.

In dem Gehäuse 110 ist zumindest teilweise eine Platine 120 angeordnet.

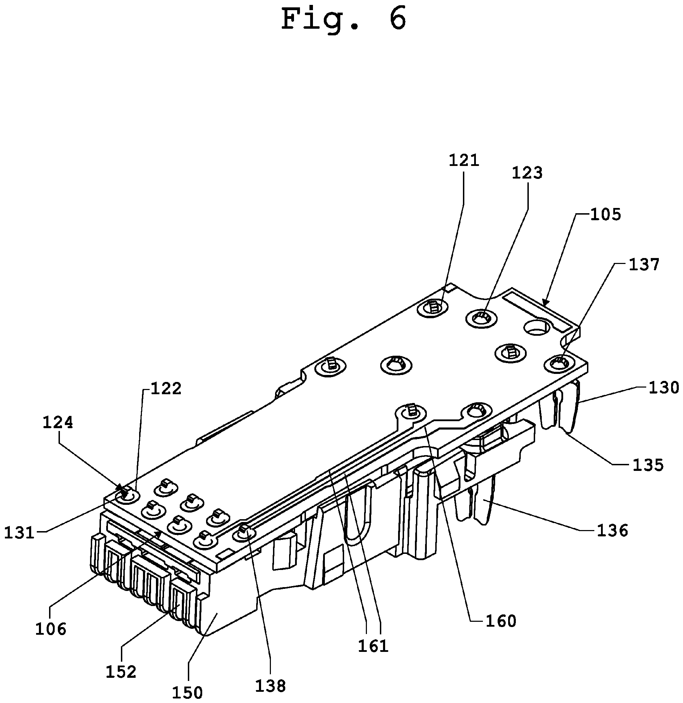

In Fig. 6 ist eine mit ersten Kontaktelementen 130 versehene Platine 120 mit aufgesetztem Trägerelement abgebildet. Die Platine 120 weist erste Kontaktpads 121 auf. Die ersten Kontaktpads 121 sind kreisringförmig um eine erste Kontaktöffnung 123 angeordnet. Die ersten Kontaktelemente 130 weisen einen Stift 137 auf. Die ersten Kontaktelemente 130 sind vorzugsweise als Schneidklemmen 135 ausgebildet. Die Schneidklemmen 135 weisen eine Schneidklemmenfläche 136 auf. Die Schneidklemmen sind in zwei Gruppen angeordnet, wobei die Schneidklemmenfläche 136 der einzelnen Schneidklemmen 135 einen Winkel gegenüber der Kante 105 der Anschlussseite 103 aufweisen. Die Schneidklemmen 135 können ebenfalls senkrecht oder parallel zur Kante 105 der Anschlussseite 103 ausgerichtet sein. Die Schneidklemmen können in mehr oder weniger als zwei Gruppen angeordnet sein. Die Schneidklemmen 135 sind in Richtung des Gehäuseunterteils 111 ausgerichtet.

Die Platine 120 weist zudem zweite Kontaktpads 122 auf. Die zweiten Kontaktpads 122 sind kreisringförmig um eine zweite Kontaktöffnung 124 angeordnet. Die zweiten Kontaktelemente 131 weisen einen Stift 138 auf. Die zweiten Kontaktelemente 131 sind in zwei Gruppen angeordnet, wobei die zweiten Kontaktelemente 131 senkrecht in Richtung der Kante 106 der Steckseite 104 ausgerichtet sind. Die zweiten Kontaktelemente 131 sind in Schlitze 152 des Trägerelements 150 einführbar. Die Schlitze 152 des Trägerelements erstrecken sich von der Kante 106 der Steckseite 104 entlang der Längsachse des Steckverbinders 102 in Richtung Kante 105 der Anschlussseite 103 des Steckverbinders 102.

Auf der dem Gehäuseunterteil 140 zugewandten Seite der Platine 20 ist eine differentielle Leitung 161 ausgebildet. Die differentielle Leitung besteht aus zwei Leiterbahnen 160.

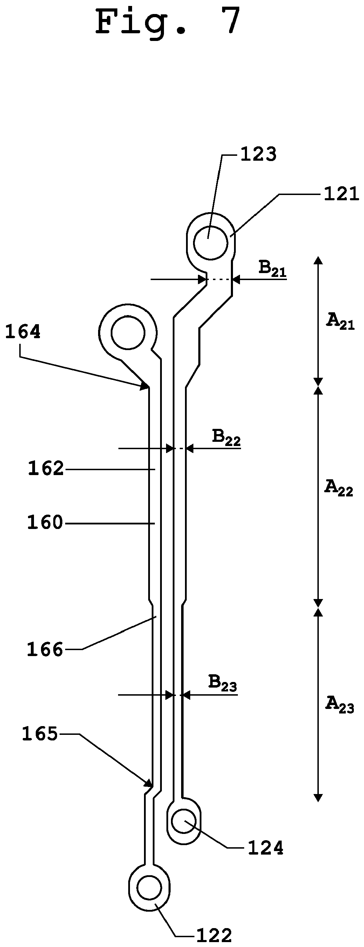

In Fig. 7 ist eine differentielle Leitung 161 abgebildet. Die differentielle Leitung 161 weist eine erste Leiterbahn 162 und eine zweite Leiterbahn 163 auf. Die differentielle Leitung 161 weist drei Leiterbahnabschnitte A21-A23 auf. Der erste Leiterbahnabschnitt A21 der beiden Leiterbahnen 160 der differentiellen Leitung 162 erstreckt sich von einem ersten Kontaktpad 121 bis zu einer senkrecht auf der Leiterbahnwand 166 im ersten Abknickpunkt 164 stehenden gedachten Linie. Im letzten Teilabschnitt des ersten Leiterbahnabschnitts A21 verjüngen sich die beiden Leiterbahnen 160 solange, bis diese die zweite Leiterbahnbreite B22 des zweiten Leiterbahnabschnitts A22 innehat. Die erste Leiterbahnbreite B21 ist damit stets breiter als die Leiterbahnbreite B22. Im verjüngenden Leiterbahnbereich des ersten Leiterbahnabschnittes A21 verlaufen die erste Leiterbahn 162 und die zweite Leiterbahn 163 parallel zueinander. Der Abstand 167 der beiden Leiterbahnen 160 einer differentiellen Leitung 161 ist in diesem Bereich gleichbleibend ausgebildet. Die Leiterbahnen 160 der differentiellen Leitung 161 können auch über den gesamten Leiterbahnabschnitt A21 parallel zueinander verlaufen.

Der zweite Leiterbahnabschnitt A22 ist zwischen dem ersten Leiterbahnabschnitt A21 und dem dritten Leiterbahnabschnitt A23 angeordnet. Die erste 162 und zweite 163 Leiterbahn 160 der differentiellen Leitung 161 weisen eine zweite Leiterbahnbreite B22 auf. Die zweite Leiterbahnbreite B22 ist über den gesamten zweiten Leiterbahnabschnitt A22 gleichbleibend ausgebildet, wobei die zweite Leiterbahnbreite B22 auch eine veränderliche Breite aufweisen kann, wobei die zweite Leiterbahnbreite B22 ausgehend von Leiterbahnabschnitt A21 zu Leiterbahnabschnitt A23 verjüngend ausgebildet ist. Der Abstand 167 der beiden Leiterbahnen 160 der differentiellen Leitung 161 ist im Leiterbahnabschnitt A22 gleichbleibend ausgebildet. Der Abstand 167 kann ebenfalls nur teilweise über den Leiterbahnabschnitt A22 gleichbleibend ausgebildet sein.

Zwischen dem zweiten Leiterbahnabschnitt A22 und einem zweiten Kontaktpad 122 ist der dritte Leiterbahnabschnitt A23 angeordnet. Der dritte Leiterbahnabschnitt A23 kann jedoch auch zwischen dem zweiten Leiterbahnabschnitt A22 und einem vierten Leiterbahnabschnitt angeordnet sein. Die Anzahl der Leiterbahnabschnitte ist nicht beschränkt. Die Leiterbahnen 160 der differentiellen Leitung 161 verlaufen ausgehend vom zweiten Leiterbahnabschnitt A22 bis zum zweiten Abknickpunkt 165 parallel zueinander. Der Abstand 167 zwischen den beiden Leiterbahnen 160 ist damit gleichbleibend ausgebildet. Der Abstand 167 der beiden Leiterbahnen 160 kann auch nur in einem Bereich des dritten Leiterbahnabschnitts A23 teilweise gleichbleibend ausgebildet sein. Die dritte Leiterbahnbreite B23 ist über den dritten Leiterbahnabschnitt A23 gleichbleibend ausgebildet. Die Leiterbahnbreite B23 kann über den dritten Leiterbahnabschnitt A23 lediglich teilweise gleichbleibend ausgebildet sein. Die Leiterbahnbreite B23 ist ausgehend vom zweiten Leiterbahnabschnitt A22 bis zu seinem Ende stets gleichbleibend oder verjüngend ausgebildet.

Der Übergang zwischen den einzelnen Leiterbahnabschnitten kann stufenweise oder stetig erfolgen.

Die erste Leiterbahn 162 der differentiellen Leitung 161 weist im zweiten Abknickpunkt 165 einen Knick auf. Dieser bewirkt, dass der Abstand zwischen der ersten Leiterbahn 162 und das zweite Kontaktpad 122 der zweiten Leiterbahn 163 einen genügend großen Abstand zueinander aufweisen, sodass die Grenzwerte für Kriechstrecken eingehalten werden.

### Bezugszeichenliste

- 1: Elektrischer Verbinder
- 2: Anschlussdose
- 8: Mittelsteg
- 9: Erhebung
- 10: Gehäuse
- 11: Gehäuseoberteil
- 12: Deckenfläche
- 13: Gehäuseumwandung
- 14: Seitenfläche
- 15: Führungsausnehmung
- 16: Randbereich
- 17: Freiraum
- 18: Aussparung
- 19: Freifläche
- 20: Platine
- 21: Erstes Kontaktelement
- 22: Zweites Kontaktelement
- 23: Zweites Kontaktpad
- 24: Einbuchtung
- 25: Seite
- 26: Schneidklemmen
- 27: Schneidklemmenfläche
- 28: Schneidklemmenpaar
- 29: Platinenmittelpunkt
- 30: Zweite Kontaktöffnung
- 31: Ausnehmung
- 32: Stab
- 33: Erstes Kontaktpad
- 34: Erste Kontaktöffnung
- 35: Erste Kontaktelemente
- 36: Stift
- 40: Gehäuseunterteil
- 41: Seite
- 42: Grundplatte
- 43: Führungselemente
- 44: Kabeleingangsöffnung
- 50: Buchse
- 52: Ausgangsöffnung
- 60: Leiterbahn
- 62: Differentielle Leitung
- 63: Abstand Leiterbahnen
- 64: Stufen
- 65: Stichleitung
- 66: 1. Abknickpunkt
- 67: 2. Abknickpunkt
- 68: 3. Abknickpunkt
- 69: 4. Abknickpunkt
- 70: 1. Kontaktpunkt
- 71: Kondensatorplatte
- 72: 2. Kontaktpunkt
- 73: Erste Leiterbahn
- 74: Zweite Leiterbahn
- 75: Erster Kontaktbereich
- 76: Zweiter Kontaktbereich
- 77: Leiterbahnwand
- 78: 5. Abknickpunkt

- 102: Steckverbinder
- 103: Anschlussseite
- 104: Steckseite
- 105: Kante Anschlussseite
- 106: Kante Steckseite
- 109: Gehäuseseite
- 110: Gehäuse
- 111: Gehäuseoberteil
- 112: Aussparung
- 113: Vorderes Haltemittel
- 114: Hinteres Haltemittel
- 120: Platine
- 121: Erste Kontaktpads
- 122: Zweite Kontaktpads
- 123: Erste Kontaktöffnungen
- 124: Zweite Kontaktöffnungen
- 130: Erste Kontaktelemente
- 131: Zweite Kontaktelemente
- 135: Schneidklemmen
- 136: Schneidklemmenfläche
- 137: Stift
- 138: Stift
- 140: Gehäuseunterteil
- 141: Führungselement
- 142: Haltemittel
- 150: Trägerelement
- 151: Haltemittel
- 152: Schlitz
- 153: Trägerelementseite
- 160: Leiterbahn
- 161: Differentielle Leitung
- 162: Erste Leiterbahn
- 163: Zweite Leiterbahn
- 164: Erster Abknickpunkt
- 165: Zweiter Abknickpunkt
- 166: Leiterbahnwand
- 167: Abstand
- A1: Leiterbahnabschnitt 1
- A2: Leiterbahnabschnitt 2
- A3: Leiterbahnabschnitt 3
- B1: Leiterbahnbreite 1
- B2: Leiterbahnbreite 2
- B3: Leiterbahnbreite 3

- A21: Leiterbahnabschnitt 1
- A22: Leiterbahnabschnitt 2
- A23: Leiterbahnabschnitt 3
- B21: Leiterbahnbreite 1
- B22: Leiterbahnbreite 2
- B23: Leiterbahnbreite 3

## Patentansprüche

1. Elektrischer Verbinder (1) für ein Daten- oder Kommunikationskabel mit folgenden Merkmalen:
- ein Gehäuse (10),
- eine im Gehäuse (10) mindestens teilweise angeordnete Platine (20),
- erste Kontaktelemente (21) und zweite Kontaktelemente (22), welche an der Platine (20) angeordnet sind, wobei
- jedes der ersten Kontaktelemente (21) mittels einer Leiterbahn (60) mit einem zweiten Kontaktelement (22) elektrisch verbunden ist,
- mindestens einer Leiterbahn (60), welche vom ersten Kontaktelement (21) zum zweiten Kontaktelement (22) mindestens drei unterschiedliche Leiterbahnbreiten (B1-B3) aufweist,
**gekennzeichnet durch** die weiteren Merkmale:
- die Leiterbahnbreite (B1-B3) ausgehend vom zweiten Kontaktelement (22) zum ersten Kontaktelement (21) bei mindestens drei aufeinanderfolgenden Leiterbahnbreiten (B1-B3) stetig oder stufenweise abnehmend ist,
- der Abstand (63) der beiden Leiterbahnen (60) einer differentiellen Leitung (62) über jeden der mindestens drei aufeinanderfolgenden Leiterbahnbreiten (B1-B3) zumindest teilweise gleichbleibend ausgebildet ist.

2. Elektrischer Verbinder (1) nach Anspruch 1, **dadurch gekennzeichnet, dass** die Leiterbahnen (60) als differentielle Leitungen (62) ausgebildet sind und eine differentielle Leitung (62) zwei zumindest teilweise zueinander parallel verlaufende Leiterbahnen (60) aufweist.

3. Elektrischer Verbinder (1) nach Anspruch 2, **dadurch gekennzeichnet, dass** der Abstand (63) der beiden Leiterbahnen (60) einer differentiellen Leitung (62) gleichbleibend ausgebildet ist.

4. Elektrischer Verbinder (1) nach Anspruch 1, **dadurch gekennzeichnet, dass** der Impedanzwert des ersten Kontaktelements (21) einen größeren Wert aufweist, als der Impedanzwert des zweiten Kontaktelements (22).

5. Elektrischer Verbinder (1) nach einem der Ansprüche 1 bis 4, **dadurch gekennzeichnet, dass** das zweite Kontaktelement (22) als Schneidklemme (26) ausgebildet ist.

6. Elektrischer Verbinder (1) nach einem der Ansprüche 1 bis 4, **dadurch gekennzeichnet, dass** das erste Kontaktelement (21) als gebogener Steckkontakt ausgebildet ist.

7. Elektrischer Verbinder (1) nach einem der Ansprüche 1 bis 6, **dadurch gekennzeichnet, dass** die Impedanz des Bereichs der differentiellen Leitung (62), welcher dem zweiten Kontaktelement (22) am nächsten zugeordnet ist, den geringsten Impedanzwert der differentiellen Leitung (62) aufweist, wobei die Impedanz des Bereichs der differentiellen Leitung (62), welcher dem ersten Kontaktelement (21) am nächsten zugeordnet ist, den größten Impedanzwert der differentiellen Leitung (62) aufweist.

8. Elektrischer Verbinder (1) nach einem der Ansprüche 1 bis 7 **dadurch gekennzeichnet, dass** auf der Platine (20) acht erste Kontaktelemente (21) und acht zweite Kontaktelemente (22) angeordnet sind.

9. Elektrischer Verbinder (1) nach einem der Ansprüche 1 bis 8 **dadurch gekennzeichnet, dass** vier differentielle Leitungen (62) ausgebildet sind.

10. Elektrischer Verbinder (1) nach einem der Ansprüche 1 bis 9, **dadurch gekennzeichnet, dass** die Leiterbahnbreite (B1-B3) zwischen Stufen (64) bei einer stufenweisen Abnahme der Leiterbahnbreite (B1-B3) mindestens abschnittsweise konstant ausgebildet ist.

11. Elektrischer Verbinder (1) nach einem der Ansprüche 1 bis 10, **dadurch gekennzeichnet, dass** die Leiterbahnbreite (B1-B3) zwischen der stufenweisen Abnahme der Leiterbahnbreite (61) kontinuierlich abnehmend ausgebildet ist, wobei die Leiterbahnbreite (61) an der Stelle der Leiterbahn (60), welche dem zweiten Kontaktelement (22) am nächsten zugeordnet ist, am breitesten ist.

12. Elektrischer Verbinder (1) nach einem der Ansprüche 1 bis 11, **dadurch gekennzeichnet, dass** die mindestens eine Leiterbahn (60) in den Endbereichen derselben Leiterbahn (60) eine annähernd gleichbleibende Leiterbahnbreite (61) aufweist.

13. Elektrischer Verbinder (1) nach einem der Ansprüche 1 bis 12, **dadurch gekennzeichnet, dass** die Leiterbahn (60) jeweils über ein erstes Kontaktpad (23) mit dem ersten Kontaktelement (21) und über ein zweites Kontaktpad (33) mit dem zweiten Kontaktelement (22) verbunden ist.
